(19) Europäisches Patentamt
European Patent Office
Office européen des brevets

(11) Veröffentlichungsnummer : **0 380 007 B1**

# (12) EUROPÄISCHE PATENTSCHRIFT

(45) Veröffentlichungstag der Patentschrift : **23.06.93 Patentblatt 93/25**

(51) Int. Cl.$^5$ : **C08F 246/00**, G03F 7/038, G03F 7/075

(21) Anmeldenummer : **90101151.0**

(22) Anmeldetag : **20.01.90**

## (54) Strahlungsempfindliche Polymere.

(30) Priorität : **25.01.89 DE 3902115**

(43) Veröffentlichungstag der Anmeldung : **01.08.90 Patentblatt 90/31**

(45) Bekanntmachung des Hinweises auf die Patenterteilung : **23.06.93 Patentblatt 93/25**

(84) Benannte Vertragsstaaten : **BE CH DE FR GB IT LI NL SE**

(56) Entgegenhaltungen :
**EP-A- 0 261 991**
**US-A- 4 491 628**

(73) Patentinhaber : **BASF Aktiengesellschaft**
**Carl-Bosch-Strasse 38**
**W-6700 Ludwigshafen (DE)**

(72) Erfinder : **Schwalm, Reinhold, Dr.**
**Am Huettenwingert 53**
**W-6706 Wachenheim (DE)**
Erfinder : **Boettcher, Andreas, Dr.**
**Konrad-Adenauer-Ring 38**
**W-6907 Nussloch (DE)**

EP 0 380 007 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue Saint-Denis, 75001 PARIS

## Beschreibung

Die Erfindung betrifft neue strahlungsempfindliche Polymere, die säurelabile Gruppen und Oniumsalzgruppen enthalten. Die Polarität dieser Polymeren wird durch Einwirkung von Licht und anschließende thermische Behandlung stark geändert, so daß sie sich für Photoresists eignen.

Strahlungsempfindliche Polymere sind bekannt. So werden besonders Poly-(alkyl-methacrylate) als Photoresists eingesetzt, da sie unter der Einwirkung von Licht einen Abbau des Molekulargewichts erleiden und dadurch eine höhere Löslichkeit als die hochmolekularen, nicht belichteten Bereiche aufweisen.

Als weitere Klasse sind Poly-(olefinsulfone) zu nennen, die bei Bestrahlung ebenfalls abbauen und Schwefeldioxid und Olefin freisetzen.

Strahlungsempfindliche Polymere, welche Sulfoniumsalzeinheiten im Polymeren enthalten, sind ebenfalls bekannt (vgl. H. Tagoshi und T. Endo, J.Polym.Sci., Part C: Polym. Lett., Vol. 26, 77-81 (1988); jedoch enthalten diese Polymeren keine säurelabilen Gruppen, sondern Spiroorthoester, die unter der Einwirkung von Licht vernetzen.

In der Resistliteratur sind Mischungen aus Polymeren mit säurelabilen Gruppen und Oniumsalzen als photoaktiver Komponente beschrieben (vgl. US-A-4,491,628 und DE-A-3 620 677), die unter Einwirkung von Licht große Änderungen der Polarität ergeben. So werden aus den hydrophoben t-Butylcarbonaten bzw. t-Butylethern von phenolischen Polymeren durch die Belichtung alkalilösliche phenolische Polymere erzeugt. Setzt man diese Polymeren jedoch zur Erzeugung von Resistprofilen ein, so zeigt sich ein großer Nachteil dieser Mischungen, denn anstelle der gewünschten rechteckigen Resistprofile erhält man brückenartige Strukturen. Dieser Effekt ist wahrscheinlich auf die inhomogene Verteilung der Sulfoniumsalze in der Resistschicht zurückzuführen und kann nur durch aufwendige Maßnahmen korrigiert werden.

Aufgabe der Erfindung war es, Photoresistmaterialien zur Verfügung zu stellen, die ohne negative Beeinflussung der guten Eigenschaften der beschriebenen Mischungen ein verbessertes Strukturprofil ergeben.

Überraschenderweise läßt sich diese Aufgabe durch strahlungsempfindliche Polymere lösen, die im selben Molekül säurelabile Gruppen und Oniumsalzgruppen mit nichtnucleophilen Gegenionen enthalten.

Gegenstand der vorliegenden Erfindung sind strahlungsempfindliche Polymere, die dadurch gekennzeichnet sind, daß sie im selben Molekül sowohl säurelabile Gruppen als auch Oniumsalzgruppen mit nichtnucleophilen Gegenionen enthalten und nach bildmäßiger Belichtung je nach Wahl des Entwicklers positive bzw. negative Resistmuster ergeben. Als Oniumsalzgruppen kommen vorzugsweise Sulfonium- oder Jodoniumsalzgruppen in Frage.

Die erfindungsgemäßen strahlungsempfindlichen Polymeren enthalten insbesondere Einheiten der allgemeinen Formeln (I) und (II) oder (I) und (III)

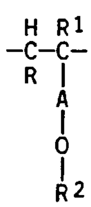

(I)

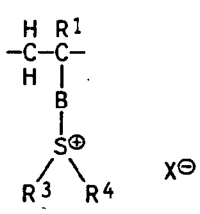

(II)

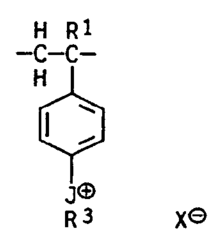

(III)

im selben Molekül einpolymerisiert, worin

A = 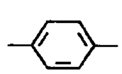 , 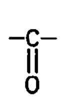 , 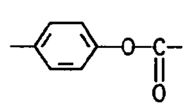 , 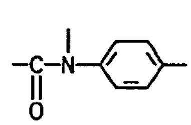 , 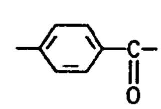 ,

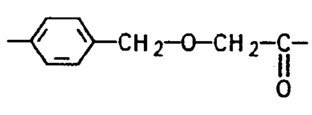 ,

B = ein zweiwertiger Rest, wie Alkylen,

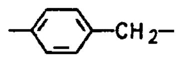 ,

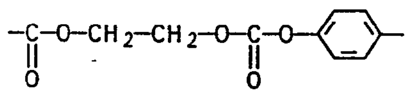 , 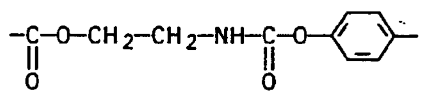

oder Phenylen,
R = H, Alkyl, Aryl, substituiertes Aryl oder für den Fall, daß

A = 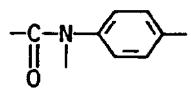

ist, eine mit dem Stickstoffatom dieser Gruppierung A verknüpfte

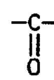Gruppe,

| | |
|---|---|
| $R^1$ | = H, Alkyl, CN, Halogen; Trihalogenmethyl, |
| $R^2$ | = säurelabile Gruppe, |
| $R^3$ und $R^4$ | untereinander gleich oder verschieden sind und für Alkyl, Aryl, substituiertes Aryl stehen oder $R^3$ mit $R^4$ zu einem 5 bis 9-gliedrigen Ring verknüpft sind, |
| $X^{\ominus}$ | = ein nichtnucleophiles Gegenion aus der Gruppe $ClO_4^{\ominus}$, $CF_3SO_3^{\ominus}$, $BF_4^{\ominus}$, $AsF_6^{\ominus}$, $SbF_6^{\ominus}$ und $PF_6^{\ominus}$. |

Die erfindungsgemäßen strahlungsempfindlichen Polymeren enthalten vorzugsweise zwischen 2 und 30 mol% Monomereinheiten mit Sulfonium- oder Jodoniumsalzgruppierungen einpolymerisiert.

Gegenstand der vorliegenden Erfindung ist auch ein positiv arbeitendes Aufzeichnungsmaterial, bei dem die belichteten Bereiche mit einem alkalischen oder polaren Lösungsmittel entfernt werden, sowie ein negativ arbeitendes Aufzeichnungsmaterial, bei dem die unbelichteten Bereiche mit unpolaren organischen Lösungsmitteln entfernt werden, wobei jeweils erfindungsgemäße strahlungsempfindliche Polymere eingesetzt werden.

Die erfindungsgemäßen strahlungsempfindlichen Polymeren eignen sich vorzüglich als Photoresiste und ergeben die gewünschten Resistprofile ohne zusätzliche Maßnahmen oder Verfahrensschritte. Sie eignen sich daher sehr vorteilhaft zur Herstellung von Halbleiterbauelementen.

Die erfindungsgemäßen strahlungsempfindlichen Polymeren können mit kurzwelligem UV-Licht, bei entsprechender Sensibilisierung auch mit längerwelligem UV-Licht, mit Elektronen- und Röntgenstrahlen belichtet werden und ergeben je nach Wahl des Entwicklers positive bzw. negative Resistmuster.

Zu den Aufbaukomponenten der erfindungsgemäßen Polymeren ist im einzelnen folgendes auszuführen. Die erfindungsgemäßen strahlungsempfindlichen Polymeren enthalten vorzugsweise Einheiten der allgemeinen Formeln (I) und (II) oder (I) und (III)

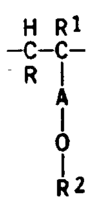

(I)

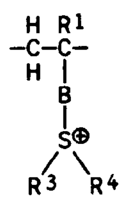 $X^{\ominus}$

(II)

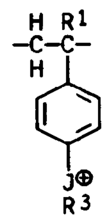 $X^{\ominus}$

(III)

im selben Molekül einpolymerisiert, worin

A beispielsweise für folgende bivalente Reste stehen kann

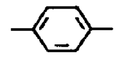 ,

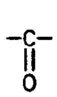 , 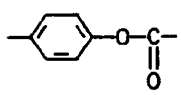 , 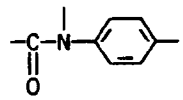 , 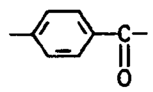 , 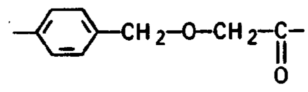 ,

B für einen als "spacer" wirkenden zweiwertiger Rest, wie Alkylen mit 1 bis 10 Kohlenstoffatomen

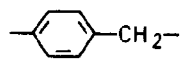 , 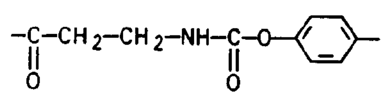

oder Phenylen,
R für H, Alkyl, beispielsweise mit 1 bis 6 Kohlenstoffatomen, wie z.B. Methyl oder Ethyl, Aryl, wie z.B. Phenyl, substituiertes Aryl, wie z.B. alkyl- oder halogen-substituiertes Phenyl oder für den Fall, daß

A = 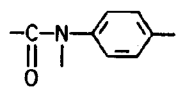

ist, für eine mit dem Stickstoffatom dieser Gruppierung A verknüpfte

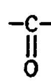Gruppe,

(d.h. als Baustein eines fünfgliedrigen Maleinimidringes)
$R^1$ für H, Alkyl, beispielsweise mit 1 bis 6 Kohlenstoffatomen, wie Methyl, Ethyl, CN, Halogen, wie z.B. Chlor oder Fluor, Trihalogenmethyl, wie z.B. Trifluormethyl;
$R^2$ steht für eine säurelabile Gruppe wie z.B. t-Alkyl-, t-Alkoxycarbonyl-, Trialkylsilyl-, Tetrahydropyranyl- oder α,α-Dialkylbenzyl-;
$R^3$ und $R^4$ können untereinander gleich oder verschieden sein und für Alkyl, beispielsweise mit 1 bis 6 Kohlenstoffatomen, wie z.B. Methyl oder Ethyl, Aryl, z.B. Phenyl, substituiertes Aryl, beispielsweise Alkylphenyl, Halogenphenyl oder Methoxyphenyl stehen oder $R^3$ kann mit $R^4$ zu einem 5 bis 9-gliedrigen Ring verknüpft sein, wie z.B. zu einem Tetrahydrothiophenring;
$X^{\ominus}$ steht für ein nichtnucleophiles Gegenion wie z.B. $ClO_4^{\ominus}$, $CF_3SO_3^{\ominus}$, $BF_4^{\ominus}$, $AsF_6^{\ominus}$, $SbF_6^{\ominus}$ und $PF_6^{\ominus}$.

Bevorzugt werden erfindungsgemäß Copolymere aus Monomeren, welche säurelabile Gruppen sowie Monomeren, welche Sulfoniumsalzgruppierungen enthalten.

Beispiele für Monomere mit säurelabilen Gruppen (I) sind entsprechend substituierte Styrole, substituierte Ester der Acryl- oder Methacrylsäure oder substituierte Maleinimide z.B. folgender Strukturen:

Ia) 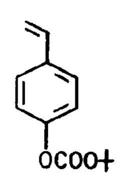 Ib) 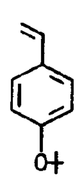 Ic) 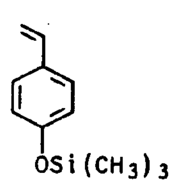 Id) 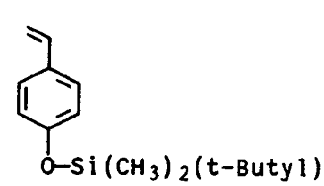

Ie) 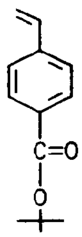

If) 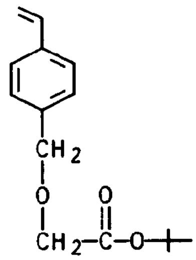

Ig) 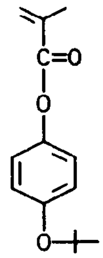

Ih) 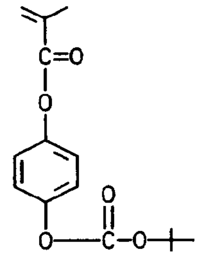

Ii) 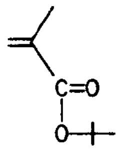

Ij) 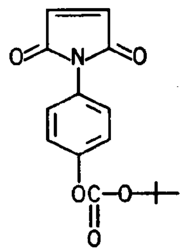

Ik) 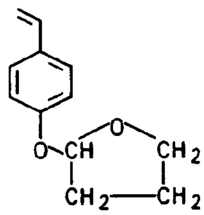

Il) 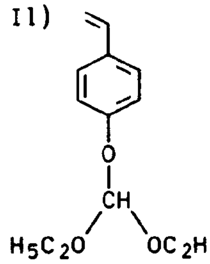 ;

Beispiele für Monomere mit Sulfoniumgruppen sind:

IIa) 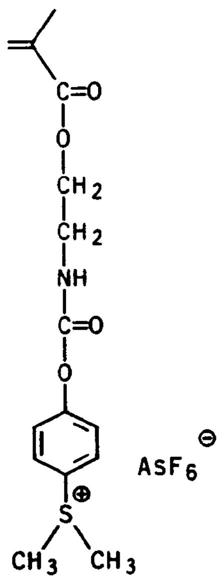

IIb) 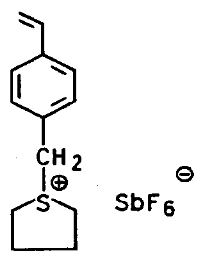

IIc) 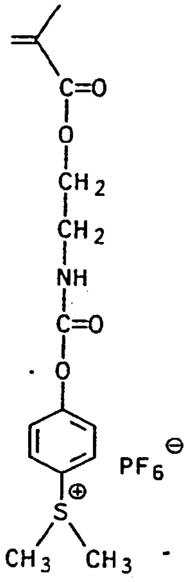 IId) 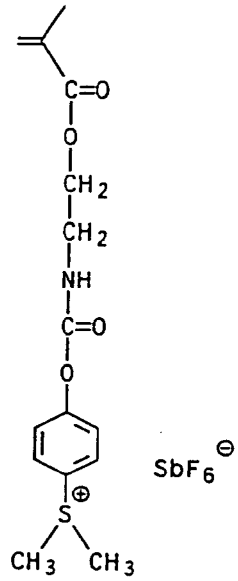 IIe) 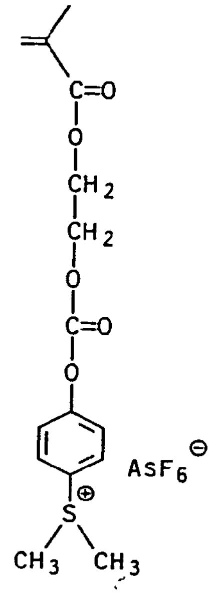

Obwohl diese Monomeren bevorzugt sind, können alle in der gleichzeitig eingereichten Patentanmeldung DE-A- 3 902 114 beschriebenen Monomeren eingesetzt werden, in der strahlungsempfindliche, ethylenisch ungesättigte, copolymerisierbare Sulfoniumsalze der allgemeinen Formel

$$[(R)_a(R^1)_b(R^2)_c\overset{\oplus}{S}] \quad A^{\ominus} \qquad (I),$$

sowie deren Herstellung beansprucht und beschrieben werden, wobei in dieser Formel

R einen, gegebenenfalls substituierten, einwertigen aromatischen organischen Rest bedeutet,

$R^1$ einen, gegebenenfalls substituierten, einwertigen organischen aliphatischen Rest aus der Gruppe der Alkyl-, Cycloalkyl- und substituierten Alkylreste bedeutet,

$R^2$ einen, gegebenenfalls substituierten, zwei- oder dreiwertigen aliphatischen oder aromatischen organischen Rest bedeutet, der eine heterocyclische oder kondensierte Ringstruktur bildet,

a eine ganze Zahl von 0 bis einschließlich 3 ist,

b eine ganze Zahl von 0 bis einschließlich 2 ist,

c eine ganze Zahl gleich 0 oder 1 ist,

wobei die Summe a+b+c=3 ist und

$A^{\ominus}$ für das Anion einer Säure steht

und mindestens einer der Reste R bis $R^2$ einen der Reste

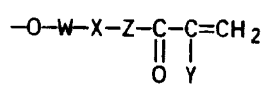

oder

$$-O-W-X-Z-CH=CH_2$$

gebunden enthält, worin

W für eine Einfachbindung, oder eine der Gruppen

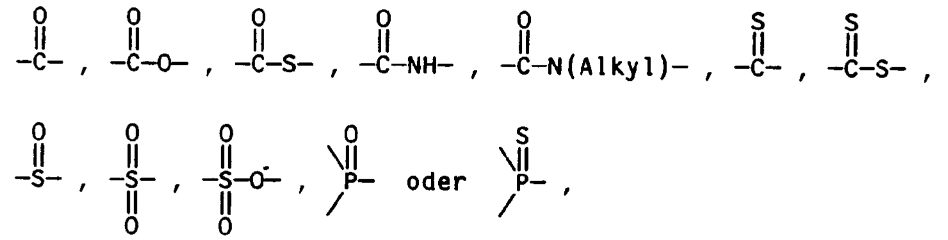

oder

X für einen zweiwertigen, gegebenenfalls substituierten, Alkylenrest $-(CH_2)_m-$, einen Rest

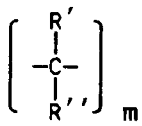

,

mit m = 1 bis 10,
worin R' und R" untereinander gleich oder verschieden sind und für Aryl, $C_1$- bis $C_4$-Alkyl, H, COOH, $COOCH_3$ oder $COOC_2H_5$ stehen,
einen perfluorierten Alkylenrest $-(CF_2)_m-$ mit m = 1 bis 10, einen Oxaalkylenrest $-(CH_2)_n-O-(CH_2)_p-$mit n = 1 bis 5 und p = 1 bis 5, einen perfluorierten Oxaalkylenrest $-(CF_2)_n-O-(CF_2)_p-$ mit n, p = 1 bis 5, oder einen, gegebenenfalls perfluorierten, Polyoxaalkylenrest mit 2 bis 20 Sauerstoffatomen, die miteinander über mindestens eine $-CH_2-$, $-CF_2-$ oder $-CH_2-CH(CH_3)-$Gruppe verbunden sind, für einen der Reste $-(CH_2)_m-O-CO-O-(CH_2)_n-$, $-(CH_2)_n-O-CO-NH-(CH_2)_m-$, $-(CH_2)_n-NH-CO-O-(CH_2)_m-$, $-(CH_2)_m-CO-O-(CH_2)_n-$ oder $-(CH_2)_m-O-CO-(CH_2)_n-$ mit m = 1 bis 10, n = 1 bis 10, einen gegebenenfalls mit Alkyl mit 1 bis 4 Kohlenstoffatomen, OH, $OCH_3$, $OC_2H_5$, SH, $SCH_3$, $SC_2H_5$, Cl, F, $N(Alkyl)_2$ oder $N(CH_3)C_6H_5$ in o-, m- und/oder p-Stellung substituierten, Phenylen-, oder einen Cycloalkylenrest mit 5 bis 10 Kohlenstoff-Atomen oder für einen (Bis)methylencycloalkylenrest mit 6 bis 12 Kohlenstoffatomen steht,

Y für H, Alkyl mit 1 bis 6 Kohlenstoffatomen oder Phenyl und

Z für O oder NY stehen.

Besonders bevorzugte Copolymere sind solche aus p-t-Butoxycarbonyloxistyrol und Comonomer IIa, p-t-Butoxicarbonyloxistyrol und Comonomer IIb, p-t-Butoxistyrol und Comonomer IIa, p-t-Butoxistyrol und Comonomer IIb, p-Vinyl-benzoesäure-t-butylester und Comonomer IIa, p-Trimethylsilyloxistyrol und Comonomer IIa sowie p-Trimethylsilyloxistyrol und Comonomer IIb.

Der Gehalt der erfindungsgemäßen Polymeren an einpolymerisierten Einheiten von Comonomeren mit Sulfonium- bzw. Jodoniumsalzgruppen (II) beträgt im allgemeinen 1 bis 50, vorzugsweise 2 bis 30, insbesondere 2 bis 20 mol% des Polymeren.

Die Herstellung der erfindungsgemäßen Polymeren kann durch Copolymerisation der Comonomeren (I) und (II) auf übliche Weise, beispielsweise durch radikalische Polymerisation mit Azoinitiatoren erfolgen.

Obwohl diese Copolymeren bevorzugt sind, können die säurelabilen und Sulfoniumsalzgruppen auch anders, beispielsweise durch polymeranaloge Umsetzung oder durch Polyadditions- oder Polykondensationsreaktionen in das strahlungsempfindliche Polymere eingeführt werden.

Weiterhin ist die Erfindung nicht auf die genannten säurelabilen Gruppen beschränkt, sondern es können eine große Anzahl von anderen bekannten säurelabilen Gruppen wie Trityl-, Benzyl-, Acetale usw. ebenfalls als $R^2$ eingesetzt werden.

Das Molekulargewicht der erfindungsgemäßen Polymeren liegt im allgemeinen zwischen 5.000 und 200.000, vorzugsweise 10.000 und 80.000 ($\overline{M}_w$: Lichtstreuung).

Für die Weiterverarbeitung und Verwendung werden die erfindungsgemäßen Polymeren im allgemeinen in einem geeigneten Lösungsmittel, z.B. Ethylenglykol-ethylether-acetat, Cyclohexanon, oder Methylpropylenglykolacetat gelöst, als dünner Film von ca. 1 bis 2 µm auf ein Substrat, beispielsweise einen Siliziumwafer aufgebracht, unter kontrollierten Bedingungen, z.B. zwischen 60 und 120°C ausgeheizt, bildmäßig belichtet und nochmals unter kontrollierten Bedingungen, zwischen 40 und 120°C ausgeheizt.

Danach können entweder die belichteten Bereiche mit einem alkalischen oder polaren Lösungsmittel, oder die unbelichteten Bereiche mit einem unpolaren Lösungsmittel entfernt werden.

Besonders geeignet sind die erfindungsgemäßen Polymeren für die Belichtung im kurzwelligen UV-Bereich, da die photoaktiven Sulfoniumgruppen unterhalb 300 nm (im sogenannten tiefen UV) absorbieren. Als

Belichtungsquellen kommen Excimer Laser (KrF: 248 nm) oder Hg-Niederdrucklampen ($\lambda$ = 257 nm) in Frage. Es ist jedoch auch möglich, die Polymeren mit Hilfe von zugesetzten Sensibilisatoren, z.B. polycyclische Aromaten, wie Perylen, zu sensibilisieren, so daß eine Belichtung mit langwelligem UV-Licht möglich ist.

Geeignete Entwickler für die Positiventwicklung sind polare Lösungsmittel, wie beispielsweise Isopropanol oder alkalische Lösungen im pH-Wertbereich oberhalb 11, z.B. wäßrige Lösungen von Alkalihydroxyden, Tetraalkylammoniumhydroxiden oder Aminen.

Geeignete Entwickler für den Negativmodus sind unpolare organische Lösungsmittel, wie beispielsweise Dichlormethan/Hexan-Mischungen, Chlorbenzol oder Anisol.

Die erfindungsgemäßen strahlungsempfindlichen Polymeren eignen sich zur Herstellung von Photoresists, insbesondere zur Herstellung von Resists für die Mikrolithographie sowie als Leiterplattenresiste. Sie zeichnen sich insbesondere durch hohe Empfindlichkeit und hohe Auflösung mit idealem rechteckigen Resistprofil aus.

Die in den Beispielen genannten Teile und Prozente sind, soweit nicht anders angegeben, Gewichtsteile bzw. Gewichtsprozente.

Die Herstellung von Halbleiterbauelementen unter Verwendung der erfindungsgemäßen strahlungsempfindlichen Polymeren erfolgt in üblicher Weise mit Hilfe der Photolithographietechnik, wie sie beispielsweise in "Peter Kästner, Halbleitertechnologie", Vogel-Verlag Würzburg 1980, Seiten 75 bis 117 beschrieben ist.

Beispiele für Monomersynthesen:

I. Monomere mit säurelabilen Seitengruppen:

p-t-Butoxicarbonyloxi-styrol wird analog der Vorschrift in US-A-4,491,691 hergestellt.

p-Trimethylsilyloxi-styrol wird analog der Vorschrift in EP-A-178 208 synthetisiert.

p-t-Butoxi-styrol wird durch Wittig Reaktion von p-t-Butoxi-benzaldehyd mit Methyl-triphenylphosphoniumbromid hergestellt.

II. Monomere mit Sulfoniumsalzen in der Seitengruppe:

Das Sulfoniumsalz IIa wird durch Umsetzung von Dimethyl-4-hydroxiphenylsulfoniumhexafluoroarsenat (gemäß Synthesevorschrift in J.Polym.Sci., Polym.Chem.Ed., 18, 1021 (1980)) durch Umsetzung mit Isocyanatoethylmethacrylat erhalten.

| Elementaranalyse: | C | H | S | As |
|---|---|---|---|---|
| ber.: | 36.1 | 4.0 | 6.4 | 15.0 |
| gef.: | 34.8 | 4.1 | 6.8 | 15.7 |

Analog wurden auch die Sulfoniumsalze mit anderen Gegenionen, wie $SbF_6^{\ominus}$ und $PF_6^{\ominus}$ hergestellt.

Das Sulfoniumsalz IIb wird gemäß einer Synthesevorschrift in J.Polym.Sci. Part C: Polym. Lett., Vol. 26, 79 (1988) hergestellt.

Beispiel 1

Polymerisation

2 Teile des Umsetzungsproduktes von Dimethyl-4-hydroxyphenyl-sulfonium hexafluoroarsenat mit Isocyanatoethyl-methacrylat werden zusammen mit 3,5 Teilen 4-t-Butoxicarbonyloxi-styrol, 0,066 Teilen Azo-isobutyronitril und 5 Teilen Toluol während 8 Stunden bei 70°C erhitzt. Die viskose Lösung wird mit Aceton verdünnt und das Polymere in Ligroin ausgefällt. Nach zweimaligem Umfällen resultieren 2,1 Teile Copolymer. IR- und NMR-Spektren zeigen das Vorhandensein beider Monomerkomponenten im Copolymerisat.

| | | | | | |
|---|---|---|---|---|---|
| Elementaranalyse: (%) | C 58.4 | H 6.4 | S 2.2 | As 5.5 | F 8.4 |
| Atomverhältnis: | 11 | 14 | 0.16 | 0.17 | 1.0 |

Lithographie:

Eine Photoresistlösung wird aus 20 Teilen des synthetisierten Polymers und 80 Teilen Methylpropylenglykolacetat hergestellt und durch einen Filter mit der Porenweite 0,2 µm filtriert. Die Resistlösung wird auf einen Siliziumwafer aufgeschleudert, so daß eine Schichtdicke von ca. 1 µm resultiert. Anschließend wird der Wafer 1 Minute bei 90°C ausgeheizt und mit einer strukturierten Testmaske im Kontaktverfahren während 7 Sekunden mit Excimer-Laserlicht der Wellenlänge 248 nm belichtet. Man heizt anschließend 60 Sekunden bei 80°C aus und entwickelt dann während 60 Sekunden mit einer 20 %igen wäßrigen Lösung von Hydroxyethylpiperidin. Es entsteht ein positives Bild der Maske. Rasterelektronenmikroskopische Aufnahmen zeigen gut aufgelöste 1 µm Resiststrukturen mit einem scharfen Kantenprofil.

Beispiel 2

Die Photoresistlösung aus Beispiel 1 wird wie dort beschrieben verarbeitet, jedoch wird anstatt des alkalischen Entwicklers mit reinem Anisol während 20 Sekunden entwickelt. Es entstehen negative Resistmuster.

Beispiel 3

2,0 Teile Vinylbenzylsulfoniumsalz (IIb), hergestellt gemäß Vorschrift in J.Polym.Sci.: Part C: Polymer Letters, Vol. 26, 79 (1988) und 4,0 Teile 4-t-Butoxicarbonyloxi-styrol werden in 6 Teilen Tetrahydrofuran gelöst, mit 0,07 Teilen Azo-isobutyronitril versetzt und 8 Stunden bei 70°C erhitzt. Das Copolymere wird in Ligroin gefällt. Lithographische Untersuchungen analog Beispiel 1 und 2 zeigen, daß das Polymere photoempfindlich ist und sich sowohl negativ als auch positiv entwickeln läßt, wobei Resiststrukturen mit nahezu rechteckigem Profil ohne Brückenbildung resultieren.

Beispiel 4

Es wird wie in Beispiel 3 verfahren, jedoch werden anstatt 4,0 Teilen 4-t-Butoxicarbonyloxi-styrol 8,0 Teile p-Trimethylsilyloxi-styrol eingesetzt.

Beispiel 5

2,0 Teile Sulfoniumsalz (IIa) und 7,0 Teile p-tert.-Butoxi-styrol werden in 4 Teilen Toluol gelöst und mit 0,07 Teilen Azo-bis-isobutyronitril versetzt. Das Polymere wird in Ligroin ausgefällt und bei 50°C im Vakuum getrocknet. Lithographische Untersuchungen analog Beispiel 1 und 2 zeigen, daß sich ebenfalls positive und negative Resistmuster herstellen lassen. Es lassen sich 1 µm Resiststrukturen auflösen. Die Strukturen haben nahezu senkrechte Flanken.

## Patentansprüche

1. Strahlungsempfindliche Polymere, dadurch gekennzeichnet, daß sie im selben Molekül sowohl säurelabile Gruppen als auch Oniumsalzgruppen mit nichtnucleophilen Gegenionen enthalten und nach bildmäßiger Belichtung je nach Wahl des Entwicklers positive bzw. negative Resistmuster ergeben.

2. Strahlungsempfindliche Polymere nach Anspruch 1, dadurch gekennzeichnet, daß sie als Oniumsalzgruppen Sulfonium- oder Jodoniumsalzgruppen enthalten.

3. Strahlungsempfindliche Polymere nach Anspruch 1 oder 2, dadurch gekennzeichnet, daß sie Einheiten der allgemeinen Formeln (I) und (II) oder (I) und (III)

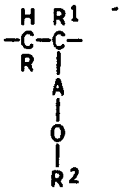
(I)

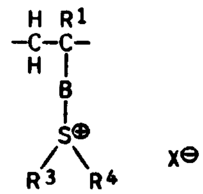
(II)

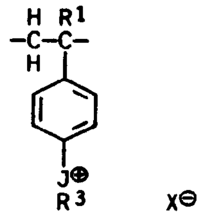
(III)

im selben Molekül einpolymerisiert enthalten, worin

A = 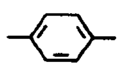 , 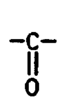 , 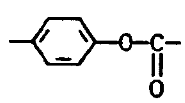 , 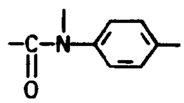 , 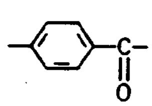 ,

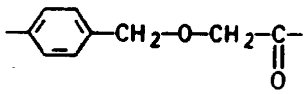 ,

B = ein zweiwertiger Rest aus der Gruppe Alkylen,

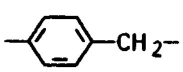 ,

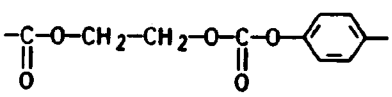 , 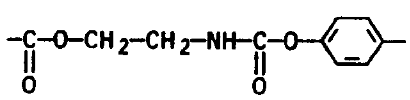

oder Phenylen

R = H, Alkyl, Aryl, substituiertes Aryl oder für den Fall, daß

A = 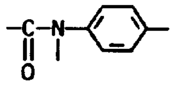

ist, eine mit dem Stickstoffatom dieser Gruppierung A verknüpfte

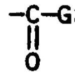Gruppe,

| | |
|---|---|
| $R^1$ | = H, Alkyl, CN, Halogen, Trihalogenomethyl, |
| $R^2$ | = säurelabile Gruppe, |
| $R^3$ und $R^4$ | untereinander gleich oder verschieden sind und für Alkyl, Aryl, substituiertes Aryl stehen oder $R^3$ mit $R^4$ zu einem 5 bis 9-gliedrigen Ring verknüpft sind, |
| $X^{\ominus}$ | = ein nichtnucleophiles Gegenion aus der Gruppe $ClO_4^{\ominus}$, $CF_3SO_3^{\ominus}$, $BF_4^{\ominus}$, $AsF_6^{\ominus}$, $SbF_6^{\ominus}$ und $PF_6^{\ominus}$. |

4. Strahlungsempfindliche Polymere nach einem der Ansprüche 1 bis 3, dadurch gekennzeichnet, daß sie als säurelabile Gruppen tert.-Alkyl-, tert.-Alkoxycarbonyl-, Trialkylsilyl- oder Tetrahydropyranylgruppen

enthalten.

5. Strahlungsempfindliche Polymere nach einem der Ansprüche 1 bis 4, dadurch gekennzeichnet, daß sie zwischen 2 und 30 mol% Monomereinheiten mit Sulfonium- oder Jodoniumsalzgruppierungen einpolymerisiert enthalten.

6. Strahlungsempfindliche Polymere nach einem der Ansprüche 3 bis 5, dadurch gekennzeichnet, daß sie aus polymerisierten Einheiten der Formel

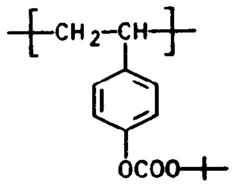

und

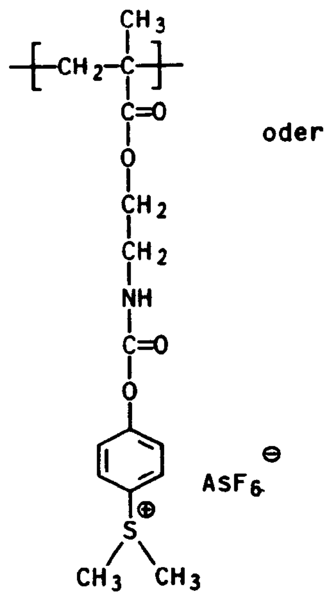

oder

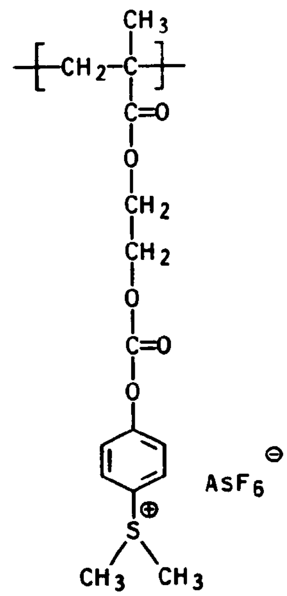

bestehen.

7. Strahlungsempfindliche Polymere nach einem der Ansprüche 3 bis 5, dadurch gekennzeichnet, daß sie aus polymerisierten Einheiten der Formel

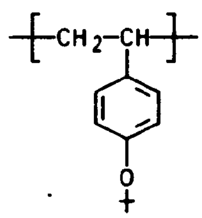

und

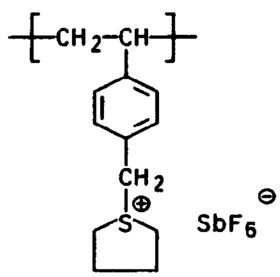

bestehen.

8. Strahlungsempfindliche Polymere nach einem der Ansprüche 3 bis 5, dadurch gekennzeichnet, daß sie aus polymerisierten Einheiten der Formel

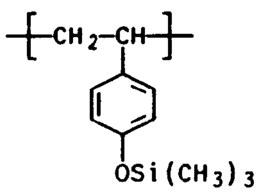

und

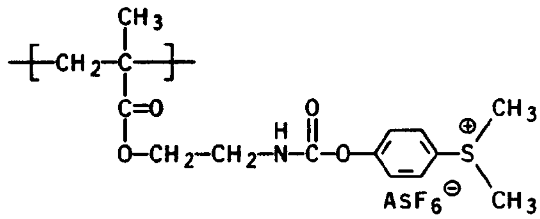

bestehen.

9. Positiv arbeitendes Aufzeichnungsmaterial, bei dem die belichteten Bereiche mit einem alkalischen oder polaren Lösungsmittel entfernt werden, dadurch gekennzeichnet, daß strahlungsempfindliche Polymere gemäß einem der vorhergehenden Ansprüche eingesetzt werden.

10. Negativ arbeitendes Aufzeichnungsmaterial, bei dem die unbelichteten Bereiche mit unpolaren organischen Lösungsmitteln entfernt werden, dadurch gekennzeichnet, daß strahlungsempfindliche Polymere gemäß einem der Ansprüche 1 bis 8 eingesetzt werden.

11. Verfahren zur Herstellung von Halbleiterbauelementen, dadurch gekennzeichnet, daß man ein strahlungsempfindliches Polymeres gemäß einem der Ansprüche 1 bis 8 auf ein ein Halbleitermaterial enthaltendes Substrat aufbringt, die strahlungsempfindliche Schicht in einem gewünschten Muster mit elektromagnetischer Strahlung bestrahlt, das Muster entwickelt und die Herstellung des Halbleiterbauelements in üblicher Weise zu Ende führt.

## Claims

1. A radiation-sensitive polymer which contains in one and the same molecule not only acid-labile groups but also onium salt groups with nonnucleophilic counterions and on imagewise irradiation produces positive or negative resist patterns, depending on the choice of developer.

2. A radiation-sensitive polymer as claimed in claim 1, wherein the onium salt groups are sulfonium or iodonium salt groups.

3. A radiation-sensitive polymer as claimed in claim 1 or 2, containing, copolymerized in one and the same molecule, units of the general formulae (I) and (II) or (I) and (III)

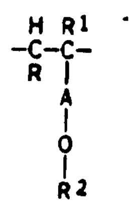

(I)

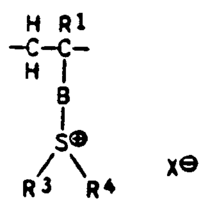

(II)

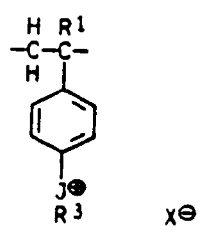

(III)

where

A = 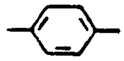 , 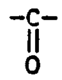 , 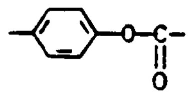 , 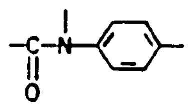 , 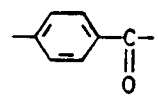 ,

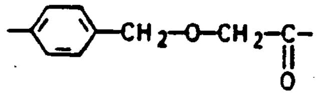 ,

B = is a divalent radical from the group consisting of alkylene,

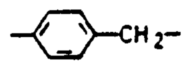 ,

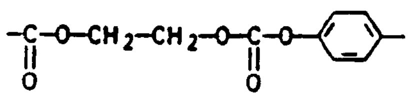 , 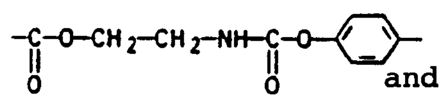 and

and phenylene,
R is H, alkyl, aryl, substituted aryl or if

A = 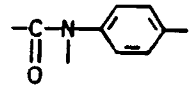 ,

a

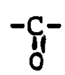

group bonded to this group A at the nitrogen atom, $R^1$ is H, alkyl, CN, halogen or trihalomethyl, $R^2$ is an acid-labile group, $R^3$ and $R^4$, which may be identical to or different from each other, are each alkyl, aryl or substituted aryl or together form 5-, 6-, 7-, 8- or 9-membered ring, and $X^{\ominus}$ is a non-nucleophilic counterion selected from the group consisting of $ClO_4^{\ominus}$, $CF_3SO_3^{\ominus}$, $BF_4^{\ominus}$, $AsF_6^{\ominus}$, $SbF_6^{\ominus}$ and $PF_6^{\ominus}$.

**4.** A radiation-sensitive polymer as claimed in any one of claims 1 to 3, wherein the acid-labile groups are tert-alkyl, tert-alkoxycarbonyl, trialkylsilyl or tetrahydropyranyl groups.

**5.** A radiation-sensitive polymer as claimed in any one of claims 1 to 4, containing as copolymerized units from 2 to 30 mol% of monomer units having sulfonium or iodonium salt groups.

**6.** A radiation-sensitive polymer as claimed in any one of claims 3 to 5, comprising polymerized units of the formulae

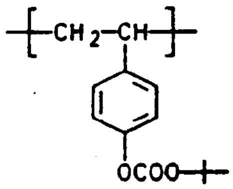

and

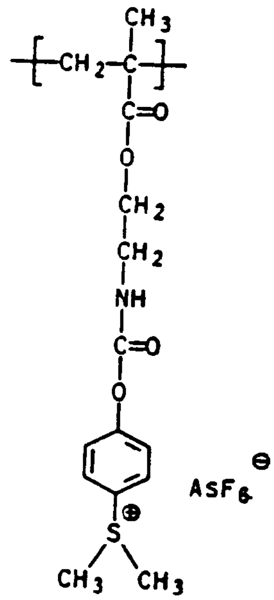

or

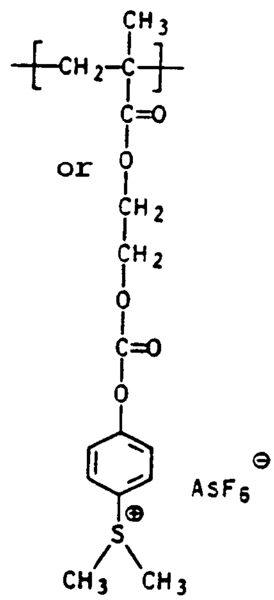

**7.** A radiation-sensitive polymer as claimed in any one of claims 3 to 5, comprising polymerized units of formulae

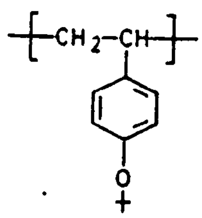

and

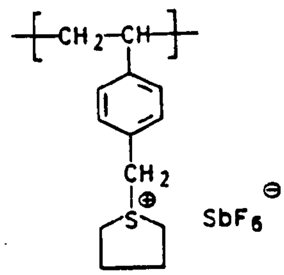

**8.** A radiation-sensitive polymer as claimed in any one of claims 3 to 5, comprising polymerized units of formulae

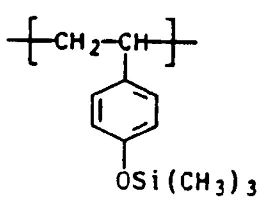

and

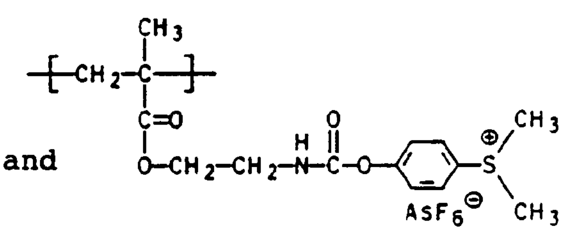

**9.** A positive-working recording element where the irradiated areas are removed with an alkaline or polar solvent, based on a radiation-sensitive polymer as claimed in any one of the preceding claims.

**10.** A negative-working recording element where the nonirradiated areas are removed with an apolar organic solvent, based on a radiation-sensitive polymer as claimed in any one of claims 1 to 8.

**11.** A process for fabricating semiconductor components, which comprises applying a radiation-sensitive polymer as claimed in any one of claims 1 to 8 to a substrate containing a semiconductor material, irradiating the radiation-sensitive layer with electromagnetic radiation in a desired pattern, developing the pattern, and completing the fabrication of the semiconductor component in a conventional manner.

## Revendications

1. Polymères sensibles aux radiations, caractérisés par le fait qu'ils contiennent dans la même molécule aussi bien des groupes métastables aux acides que des groupes de sel d'onium à contre-ions non nucléophiles et qu'après exposition à la lumière en fonction d'une image, donnent, respectivement, selon le choix du révélateur, des modèles de réserves positifs ou négatifs.

2. Polymères sensibles aux radiations selon la revendication 1, caractérisés par le fait qu'ils contiennent, comme groupes de sel d'onium, des groupes de sels de sulfonium ou d'iodonium.

3. Polymères sensibles aux radiations selon la revendication 1 ou 2, caractérisés par le fait qu'ils contiennent en polymérisation dans la même molécule des motifs de formules générales (I) et (II) ou (I) et (III)

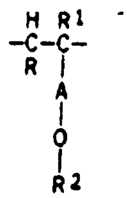
(I)

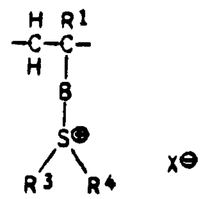
(II)

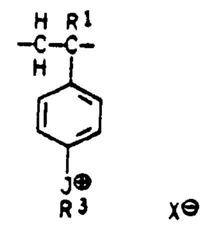
(III)

dans lesquelles

A = 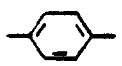 , 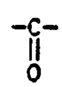 , 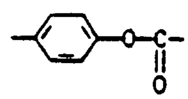 , 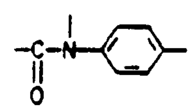 , 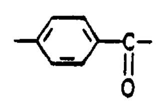 ,

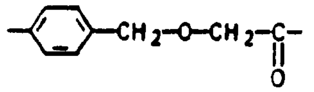 ,

B = un reste bivalent des groupes alkylène,

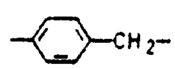 ,

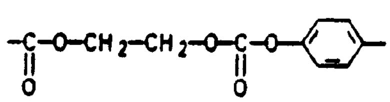 , 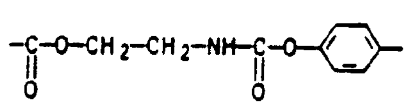

ou phénylène

R = H, alkyle, aryle, aryle substitué ou, dans le cas où

A = 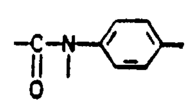

un groupe

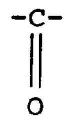

raccordé à l'atome d'azote de ce groupement A

- $R^1$ = H, alkyle, CN, halogène, trihalogénométhyle,
- $R^2$ = groupe instable aux acides,
- $R^3$ et $R^4$ sont identiques ou différents et sont mis pour alkyle, aryle, aryle substitué, ou $R^3$ et $R^4$ sont raccordés à un noyau de 5 à 9 chaînons,
- $X^{\ominus}$ = un contre-ion non nucléophile du groupe $ClO_4^{\ominus}$, $CF_3SO_3^{\ominus}$, $BF_4^{\ominus}$, $AsF_6^{\ominus}$, $SbF_6^{\ominus}$ et $PF_6^{\ominus}$.

4. Polymères sensibles aux radiations selon l'une des revendications 1 à 3, caractérisés par le fait qu'ils contiennent, comme groupes instables aux acides, des groupes tert-alkyle, tert-alcoxycarbonyle, trialkylsilyle, ou tétrahydropyranyle.

5. Polymères sensibles aux radiations selon l'une des revendications 1 à 4, caractérisés par le fait qu'ils contiennent, en polymérisation, entre 2 et 30 mol % de motifs de monomères à groupements de sels de sulfonium ou d'iodonium.

6. Polymères sensibles aux radiations selon l'une des revendications 3 à 5, caractérisés par le fait qu'ils sont constitués de motifs polymérisés de la formule

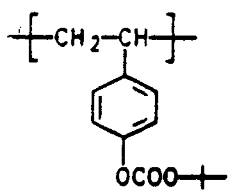

et

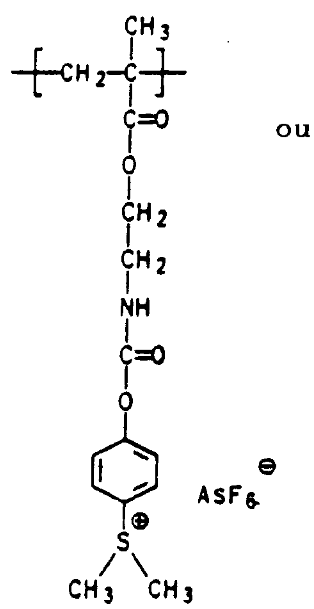

ou

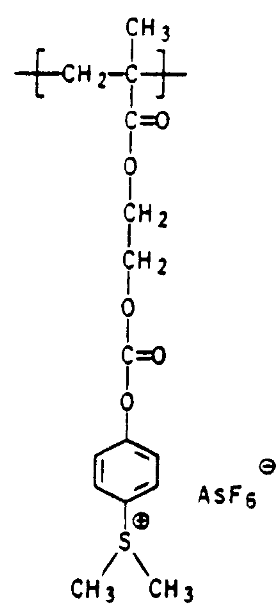

7. Polymères sensibles aux radiations selon l'une des revendications 3 à 5, caractérisés par le fait qu'ils sont constitués de motifs polymérisés de la formule

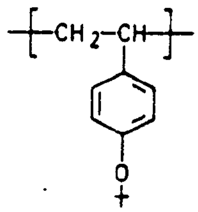

et

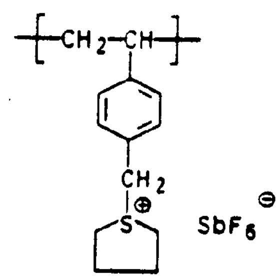

**8.** Polymères sensibles aux radiations selon l'une des revendications 3 à 5, caractérisés par le fait qu'ils sont constitués de motifs polymérisés de la formule

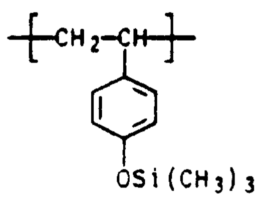

et

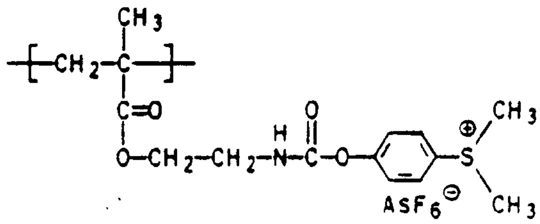

**9.** Matériaux d'enregistrement travaillant en positif pour lesquels les zones exposées à la lumière sont éliminées avec un solvant alcalin ou polaire, caractérisés par le fait que sont utilisés des polymères sensibles aux radiations selon l'une des revendications précédentes.

**10.** Matériaux d'enregistrement travaillant en négatif pour lesquels les zones non exposées à la lumière sont éliminées avec un solvant organique non polaire, caractérisés par le fait que sont utilisés des polymères sensibles aux radiations selon l'une des revendications 1 à 8.

**11.** Procédé de fabrication d'éléments semi-conducteurs caractérisé par le fait que l'on applique un polymère sensible aux radiations selon l'une des revendications 1 à 8 sur un substrat contenant un matériau semi-conducteur, on irradie, dans un modèle voulu, par radiation électromagnétique, la couche sensible aux radiations, on développe le modèle et on mène à bonne fin de la manière usuelle la fabrication de l'élément semi-conducteur.